# EUROPEAN PATENT APPLICATION

(11) **EP 1 104 102 A1**
(43) Date of publication of application: **30.05.2001**
(21) Application number: 00309462.0
(22) Date of filing: 27.10.2000
(51) Int. Cl.: H03J 1/00

(54) **Active filter and method of adjusting a band thereof**

(30) Priority: 25.11.1999 JP 33463799
(71) Applicant: ALPS ELECTRIC CO., LTD., Ota-ku Tokyo 145 (JP)
(72) Inventor: Sato, Hiroki, c/o Alps Electric Co., Ltd., Tokyo 145 (JP)
(74) Representative: Kensett, John Hinton

(57) **Abstract**

The present invention includes an active filter (3) employed in a receiver and band-adjusting by a control voltage, a first adjustment resistor (5₁) connected between a control terminal (11) and a power terminal (6), a second adjustment resistor (5₂) connected between the control terminal (11) and ground, and an external power supply (13) selectively connected to the control terminal (11) and whose output voltage can be adjusted stepwise. First, the external power supply (13) is connected to the control terminal (11), and the output voltage of the external power supply (13) is changed stepwise. Further, the receive sensitivity of the receiver is measured each time the output voltage is changed, and the output voltage of the external power supply (13) at the acquisition of the highest receive sensitivity is detected. Next, the external power supply (13) is disconnected from the control terminal (1), and the connections of the adjustment resistors (5₁5₂) are controlled or adjusted so that the voltage at the control terminal (11) becomes substantially equal to the detected output voltage.

## Description

### BACKGROUND OF THE INVENTION

### Field of the Invention:

The present invention relates to an active filter and a method of adjusting or controlling a band thereof, and particularly to an active filter, which makes use of an active filter employed in a receiver and whose band is adjusted by a voltage value supplied to a control terminal, and selectively connects adjustment resistors to the control terminal so that the receive sensitivity of the receiver becomes the maximum, and a method of adjusting a band of the active filter.

### Description of the Related Art:

In a transmitter-receiver employed in a Digital European Cordless Telephone system (DECT system) or the like, an active filter used as an intermediate frequency filter has heretofore been used in an intermediate frequency circuit of a receiver. The present active filter is normally made up of an integrated circuit integral with an amplifier circuit, a frequency converting circuit, etc. of the receiver.

In this case, the active filter originally adopts such a circuit configuration that a pre-determined signal gain characteristic and a pre-determined frequency bandwidth characteristic are obtained. However, since the integrated circuit formed integrally with the amplifier circuit, the frequency converting circuit, etc. is used for the active filter, the manufactured integrated circuit varies in characteristic. When such an integrated circuit is installed and a transmitter-receiver of the DECT system is manufactured, it is difficult to set the signal gain characteristic and frequency bandwidth characteristic of the active filter circuit to pre-determined characteristics respectively due to variations in the characteristic of the integrated circuit. Therefore, an event often occurs that the receive sensitivity of the receiver would become lower than desired receive sensitivity.

In order to avoid such an unexpected situation, one additionally provided with the following adjusting means has already been proposed for the transmitter-receiver of the DECT system. Namely, in an adjusting or controlling process subsequent to the fabrication of the transmitter-receiver of the DECT system, a variable resistor for dividing a source voltage is connected to a control terminal of the active filter employed in the receiver. A control voltage obtained from the variable resistor is supplied to the control terminal. The receive sensitivity of the receiver is measured while the variable resistor is being adjusted to control or adjust a voltage value of the control voltage supplied to the control terminal. When the resultant receive sensitivity reaches the maximum, the control or adjustment of the variable resistor is completed, and the voltage value of the control voltage obtained at this time is always added to the active filter, whereby the signal gain characteristic and frequency bandwidth characteristic of the active filter circuit are set so as to approximate pre-determined characteristics respectively. If, in this case, the frequency bandwidth of the active filter indicates a normal frequency bandwidth when the voltage value of the control voltage has approached a minimum voltage, e.g., a ground voltage, then the frequency bandwidth thereof becomes narrower than the normal frequency bandwidth when the voltage value of the control voltage has approached a maximum voltage, e.g., the source voltage. On the other hand, when the voltage value of the control voltage approaches an intermediate voltage, e.g., a voltage equal to one-half the source voltage, the frequency bandwidth thereof becomes broader than the normal frequency bandwidth.

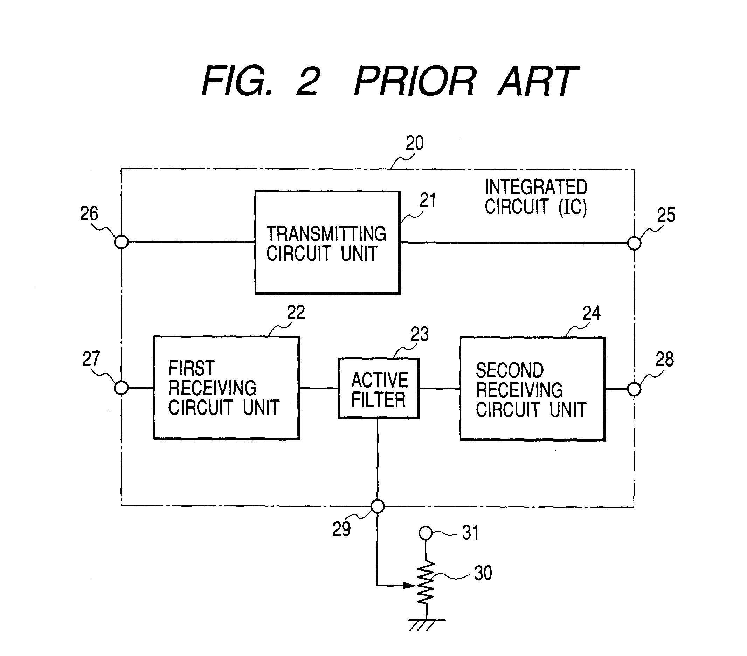

Here, Fig. 2 is a block diagram showing a principle configuration of the proposed transmitter-receiver of DECT system and shows components or constitutional parts integrally brought into integrated circuit form.

As shown in Fig. 2, the transmitter-receiver is provided with a transmitting circuit unit 21, a first receiving circuit unit 22, an active filter (intermediate frequency filter) 23, a second receiving circuit unit 24, a transmit signal input terminal 25, a transmit signal output terminal 26, a receive signal input terminal 27, a receive signal output terminal 28, a control terminal 29, a variable resistor 30, and a power terminal 31. Components or constitutional parts comprising the transmitting circuit unit 21, the first receiving circuit unit 22, the active filter 23, the second receiving circuit unit 24, the transmit signal input terminal 25, the transmit signal output terminal 26, the receive signal input terminal 27, the receive signal output terminal 28, and the control terminal 29 are made up by an integrated circuit (IC) 20.

The transmitting circuit unit 21 has an input terminal connected to the transmit signal input terminal 25 and an output terminal connected to the transmit signal output terminal 26. The first receiving circuit unit 22 has an input terminal connected to the receive signal input terminal 27 and an output terminal connected to an input terminal of the active filter 23. The second receiving circuit unit 24 has an input terminal connected to an output terminal of the active filter 23 and an output terminal connected to the receive signal output terminal 28. The active filter 23 has a band adjustment or control terminal connected to the control terminal 29. The control terminal 29 is connected to a moving contact or slider of the variable resistor 30 connected between the power terminal 31 and the ground point.

In this case, the transmitting circuit unit 21 includes a frequency converting circuit, an amplifier circuit, etc., and frequency-converts and amplifies a transmitting baseband signal supplied to the transmit signal input terminal 25 to produce or form a transmit signal having a predetermined signal level of a transmitting carrier frequency and supplies it to the transmit signal output terminal 26. The first receiving circuit unit 22 includes a frequency converting circuit, an amplifier circuit, etc., and frequency-converts and amplifies a receiving carrier frequency signal supplied to the receive signal input terminal 27 to produce or form an intermediate frequency signal and supplies it to the active filter 23. The active filter 23 comprises an intermediate frequency filter whose signal passband is controlled or adjusted by a voltage value of a control voltage supplied to the band control terminal, and selectively amplifies the intermediate frequency signal supplied thereto and supplies it to the second receiving circuit unit 24. Th second receiving circuit unit 24 includes a demodulator circuit, etc., and demodulates the supplied intermediate frequency signal, converts it into a receiving baseband signal and supplies the receiving baseband signal to the receive signal output terminal 28.

When the transmitter-receiver of the DECT system is fabricated, the integrated circuit 20 is installed to integrally form the constitutional parts comprising the transmitting circuit unit 21, the first receiving circuit unit 22, the active filter 23, the second receiving circuit unit 24, the transmit signal input terminal 25, the transmit signal output terminal 26, the receive signal input terminal 27, the receive signal output terminal 28, and the control terminal 29. Simultaneously with their integral formation, other constitutional parts integrally unformed by the integrated circuit 12 are formed, whereby the transmitter-receiver of the DECT system is manufactured.

The manufactured transmitter-receiver of the DECT system proceeds to the following adjusting process. In the present adjusting process, the variable resistor 30 is placed near the control terminal 29 of the integrated circuit 20. One end of the variable resistor 30 is connected to the power terminal 31 and the other end thereof is connected to the ground point. Further, the slider of the variable resistor 30 is connected to the control terminal 29. Thereafter, the transmitter-receiver of the DECT system is brought to an operating state to supply a control voltage from the variable resistor 30 to the band control terminal of the active filter 30 through the control terminal 29. Further, the variable resistor 30 is adjusted to control the voltage value of the control voltage supplied to the band control terminal of the active filter 23, thereby adjusting the band of the active filter 23. Each time the band thereof is adjusted, the receive sensitivity of the receiver is measured by the known measuring means, and a voltage value of a control voltage at which the receive sensitivity reaches the maximum, is detected. When the voltage value of the control voltage at which the receive sensitivity becomes the highest, is detected, the adjustment of the variable resistor 30 is completed, and the slider is fixed to its position. Subsequently, the voltage value of the control voltage is always supplied to the band control terminal of the active filter 23.

The proposed transmitter-receiver of DECT system has an advantage in that upon the adjusting process of the manufactured transmitter-receiver of DECT system, the variable resistor 30 is newly connected to the control terminal 29 and the receive sensitivity of the receiver is measured each time the variable resistor 30 is adjusted, and when the receive sensitivity reaches the maximum, the adjustment of the variable resistor 30 is completed and the voltage value of the control voltage supplied to the control terminal 29 at this time is always supplied to the band control terminal of the active filter 23, whereby the receive sensitivity of the receiver can be rendered high regardless of variations in the characteristic of the integrated circuit 20 to be used.

In the proposed transmitter-receiver of DECT system on the contrary, it is necessary to newly connect the variable resistor 30 to the receiver and place it therein upon its adjusting process. Therefore, a large voluminal portion capable of being occupied by the variable resistor 30 must be prepared within a storage container for the transmitter-receiver. Further, since a part unit price of the variable resistor 30 is relatively high, the manufacturing cost of the entire transmitter-receiver including the active filter increases and the structure of the entire transmitter-receiver becomes large in size.

### SUMMARY OF THE INVENTION

The present invention has been made in view of such a technical background. An object of the present invention is to provide a small active filter capable of simply cutting off or connecting fixed resistors to thereby set a receiver to the maximum receive sensitivity upon an adjusting process, and reducing the manufacturing cost of an active filter portion, and a method of adjusting a band of the active filter.

In order to achieve the above object, a method of adjusting a band of an active filter according to the present invention includes the active filter used in a receiver and whose band is adjusted by a voltage value supplied to a control terminal, a cutable-off first adjustment resistor connected between the control terminal and an internal power terminal, a cutable-off second adjustment resistor connected between the control terminal and a ground point, and an external power supply selectively connected to the control terminal and whose output voltage is capable of being adjusted stepwise; and has a configuration which comprises first connecting the external power supply to the control terminal, changing the output voltage of the external power supply stepwise, measuring receive sensitivity of the receiver each time the output voltage is changed, detecting the output voltage of the external power supply at the acquisition of the maximum receive sensitivity, next disconnecting the external power supply from the control terminal, and adjusting the states of connections of the first adjustment resistor and the second adjustment resistor to allow the voltage at the control terminal to be substantially equal to the detected output voltage.

According to such a configuration, when the voltage supplied to the control terminal connected to the active filter is set upon an adjusting process so that the receive sensitivity of the receiver reaches a maximum, connecting portions of the first adjustment resistor connected between the control terminal and the internal power terminal and/or the second adjustment resistor connected between the control terminal and the ground point are maintained as they are or the connecting portions are simply cut off. Therefore, newly-connected constitutional parts become unnecessary, and hence the size of a storage container can be reduced except for a portion occupied by the constitutional parts as well as a reduction in the cost equivalent to the constitutional parts, whereby the manufacturing cost of the active filter portion can be lowered and the entire structure including the active filter can be brought into less size.

Further, in order to achieve the above object, a method of adjusting a band of an active filter according to the present invention includes the active filter employed in a receiver and whose band is adjusted by a voltage value supplied to a control terminal, an internal power terminal disposed close to the control terminal, a ground terminal placed close to the control terminal, and an external power supply selectively connected to the control terminal and whose voltage is capable of being adjusted stepwise; and has another configuration which comprises first connecting the external power supply to the control terminal, changing the voltage of the external power supply stepwise, measuring receive sensitivity of the receiver each time the voltage is changed, detecting the voltage of the external power supply at the acquisition of the maximum receive sensitivity, next disconnecting the external power supply from the control terminal, and connecting a first adjustment resistor between the control terminal and the internal power terminal and/or a second adjustment resistor between the control terminal and the ground terminal to allow the voltage at the control terminal to be substantially equal to the detected voltage.

According to such another configuration, when the voltage supplied to the control terminal connected to the active filter is set upon an adjusting process so that the receive sensitivity of the receiver reaches a maximum, the first adjustment resistor and/or the second adjustment resistor are simply selectively connected between the control terminal and the internal power terminal and between the control terminal and the ground point. Further, the newly-connected constitutional parts are small and inexpensive fixed resistors alone. Therefore, as compared with the case in which the variable resistor is used as the constitutional part, the cost equivalent to the constitutional parts can be reduced, and besides the size of a storage container can be reduced because a slight preparation for a portion occupied by the constitutional parts will suffice, whereby the manufacturing cost of the active filter section or portion can be lowered and the entire structure including the active filter can be brought into less size.

Further, the external power supply employed in the present invention may preferably be one in which an output voltage thereof can be adjusted to three stages of a maximum voltage, an intermediate voltage and a minimum voltage.

According to such a configuration, when the voltages corresponding to the three stages of the maximum voltage, intermediate voltage and minimum voltage are set according to the connection or disconnection or the like of the resistors, they can be obtained by the connection of the first adjustment resistor, the connections of the first adjustment resistor and the second adjustment resistor, and the connection of the second adjustment resistor. Thus, adjustments to the first adjustment resistor and/or the second adjustment resistor become easy.

In order to achieve the above object in addition to this, an active filter according to the present invention has a configuration including an active filter employed in a receiver and whose band is adjusted by a voltage value supplied to a control terminal, a connector to which an external power supply connected to the control terminal and whose voltage is capable of being adjusted stepwise, is connectable, and adjustment resistors connected between the control terminal and an internal power terminal and/or between the control terminal and a ground point so as to measure receive sensitivity of the receiver and thereby obtain the maximum receive sensitivity.

According to such a configuration, when the receive sensitivity of the receiver is set so as to reach a maximum, the voltage supplied to the control terminal connected to the active filter is set upon an adjusting process in such a manner that the first adjustment resistor connected between the control terminal and the internal power terminal and/or the second adjustment resistor connected between the control terminal and the ground point are brought to a connected state or a disconnected state. Therefore, as compared with the case in which at least one variable resistor is used as a component or constitutional part newly connected to the control terminal, the cost equivalent to the constitutional part is reduced, and the size of a storage container is reduced because a slight preparation for a portion occupied by the constitutional part will suffice, whereby the manufacturing cost of the active filter portion or section can be lowered and the entire structure including the active filter can be brought into less size.

### BRIEF DESCRIPTION OF THE DRAWINGS

Fig. 1 is a block diagram showing a principal configuration of a transmitter-receiver of a DECT system, illustrative of an embodiment of a method of adjusting or controlling a band of an active filter according to the present invention, and shows components or constitutional parts integrally brought into integrated circuit form.

Fig. 2 is a block diagram showing a principal configuration of an already-proposed transmitter-receiver of a DECT system, and shows components or constitutional parts integrally brought into integrated circuit form.

### DESCRIPTION OF THE PREFERRED EMBODIMENTS

Embodiments of the present invention will hereinafter be described with reference to the accompanying drawings.

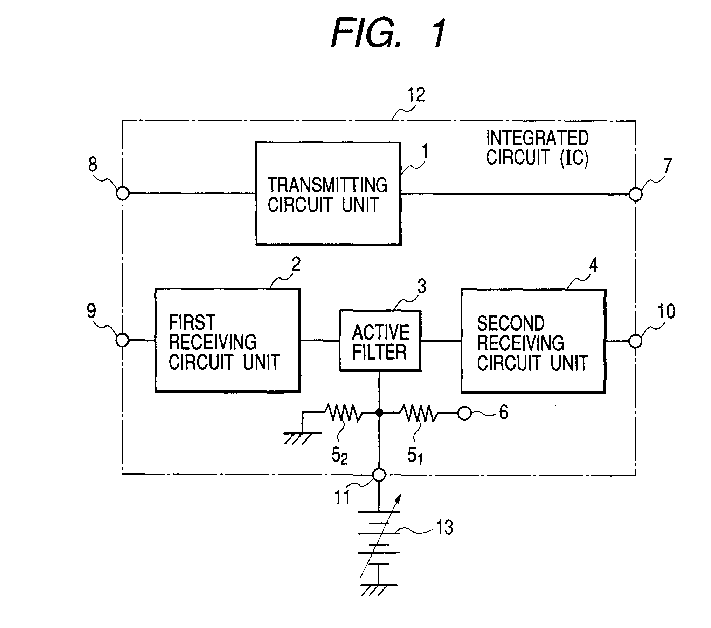

Fig. 1 is a block diagram showing a principal configuration of a transmitter-receiver of a DECT system, illustrative of an embodiment of a method of adjusting or controlling a band of an active filter according to the present invention, and shows components or constituent parts integrally brought into integrated circuit form.

As shown in Fig. 1, the transmitter-receiver of the DECT system according to the present embodiment is provided with a transmitting circuit unit 1, a first receiving circuit unit 2, an active filter (intermediate frequency filter) 3, a second receiving circuit unit 4, a first adjustment resistor 5₁, a second adjustment resistor 52, a power terminal 6, a transmit signal input terminal 7, a transmit signal output terminal 8, a receive signal input terminal 9, a receive signal output terminal 10, a control terminal 11, and an externally-connected variable voltage source or supply 13. Components or constitutional parts comprising the transmitting circuit unit 1, the first receiving circuit unit 2, the active filter 3, the second receiving circuit unit 4, the first adjustment resistor 5₁, the second adjustment resistor 52, the power terminal 6, the transmit signal input terminal 7, the transmit signal output terminal 8, the receive signal input terminal 9, the receive signal output terminal 10, and the control terminal 11 are made up by an integral or one-piece integrated circuit (IC) 12. The first adjustment resistor 5₁ and the second adjustment resistor 52 are formed on the integrated circuit 12 as printed resistors.

The transmitting circuit unit 1 has an input terminal connected to the transmit signal input terminal 7 and an output terminal connected to the transmit signal output terminal 8. The first receiving circuit unit 2 has an input terminal connected to the receive signal input terminal 9 and an output terminal connected to an input terminal of the active filter 3. The second receiving circuit unit 4 has an input terminal connected to an output terminal of the active filter 3 and an output terminal connected to the receive signal output terminal 10. The active filter 3 has a band adjustment or control terminal connected to the control terminal 11, connected to the power terminal 6 through the first adjustment resistor 5₁, and connected to a ground point through the second adjustment resistor 5₂ respectively. The variable voltage supply 13 has one output terminal connected to the control terminal 11 and the other output terminal connected to the ground point.

In this case, the transmitting circuit unit 1, the first receiving circuit unit 2, the active filter 3 and the second receiving circuit unit 4 are respectively substantially identical in configuration to a transmitting circuit unit 21, a first receiving circuit unit 22, an active filter 23 and a second receiving circuit unit 24 shown in Fig. 2. Namely, the transmitting circuit unit 1 includes a frequency converting circuit, an amplifier circuit, etc., and frequency-converts and amplifies a transmitting baseband signal supplied to the transmit signal input terminal 7 to produce or form a transmit signal having a predetermined signal level of a transmitting carrier frequency and supplies it to the transmit signal output terminal 8. The first receiving circuit unit 2 includes a frequency converting circuit, an amplifier circuit, etc., and frequency-converts and amplifies a receiving carrier frequency signal supplied to the receive signal input terminal 9 to produce or form an intermediate frequency signal and supplies it to the active filter 3. The active filter 3 comprises an intermediate frequency filter whose signal passband is controlled or adjusted by a voltage value of a control voltage supplied to the band control terminal, and selectively amplifies the intermediate frequency signal supplied thereto and supplies it to the second receiving circuit unit 4. Th second receiving circuit unit 4 includes a demodulator circuit, etc., and demodulates the supplied intermediate frequency signal, converts it into a receiving baseband signal and supplies the receiving baseband signal to the receive signal output terminal 10.

Incidentally, when the frequency bandwidth of the active filter 3 employed in the present embodiment is assumed to be indicative of a normal frequency bandwidth when the voltage value of the control voltage supplied to the band control terminal has approached a minimum voltage, e.g., a ground voltage in the same manner as the active filter 23 shown in Fig. 2, the frequency bandwidth of the active filter 3 becomes narrower than the normal frequency bandwidth when the voltage value of the control voltage has approached a maximum voltage, e.g., a source voltage. On the other hand, when the voltage value of the control voltage has approached an intermediate voltage, e.g., a voltage equal to one-half the source voltage, the frequency bandwidth of the active filter 3 becomes broader than the normal frequency bandwidth.

The fabrication of the transmitter-receiver of the DECT system, according to the present embodiment is identical to the fabrication of a transmitter-receiver of a DECT system shown in Fig. 2. The integrated circuit 12 is installed to integrally form the constitutional parts comprising the transmitting circuit unit 1, the first receiving circuit unit 2, the active filter 3, the second receiving circuit unit 4, the first adjustment resistor 5₁, the second adjustment resistor 5₂, the power terminal 6, the transmit signal input terminal 7, the transmit signal output terminal 8, the receive signal input terminal 9, the receive signal output terminal 10, and the control terminal 11. Other constitutional parts integrally unformed by the integrated circuit 12 are formed simultaneously with their integral formation, whereby the transmitter-receiver of the DECT system is manufactured.

The manufactured transmitter-receiver of DECT system proceeds to the following adjusting process in the same manner as the transmitter-receiver of the DECT system shown in Fig. 2. In the present adjusting process, the following adjustments are carried out.

To begin with, a voltage variable source or power supply 13 capable of changing an output voltage to three stages of a maximum voltage, an intermediate voltage and a minimum voltage is prepared. The voltage variable power supply 13 is connected between the control terminal of the integrated circuit 12 and the ground point. At this time, the output voltage of the voltage variable power supply 13 is supplied to the band control terminal of the active filter 3 through the control terminal 11.

Next, the transmitter-receiver of the DECT system is set to an operating state and receives a signal supplied from another transmitter-receiver of DECT system. At this time, the source voltage applied to the power terminal 6 is divided by the first adjustment resistor 5₁ and the second adjustment resistor 5₂ connected between the power terminal 6 and the ground point, followed by supply to the control terminal 11 and the band control terminal of the active filter 3. However, the output voltage of the voltage variable power supply 13 becomes dominant by selecting the respective resistance values of the first adjustment resistor 5₁ and the second adjustment resistor 5₂ as a relatively large value, e.g., about 10kΩ. Thus, the output voltage of the voltage variable power supply 13 is exclusively supplied to the control terminal 11 and the band control terminal of the active filter 3.

Next, the output voltage of the voltage variable power supply 13 is successively changed to the three stages of the maximum voltage, the intermediate voltage and the minimum voltage. The receive sensitivity of the receiver is measured by the known measuring means each time the output voltage thereof is changed thereto, whereby a voltage value of an output voltage produced from the voltage variable power supply 13, at which the receive sensitivity thereof reaches a maximum, is detected.

Next, when the voltage value of the output voltage of the voltage variable power supply 13, at which the receive sensitivity reaches the maximum, is detected, the voltage variable power supply 13 connected to the control terminal 11 is disconnected therefrom, and the connections of portions for connections of the first adjustment resistor 5₁ and/or the second adjustment resistor 5₂ are maintained or the connecting portions are cut off in such a manner that a voltage value of a control voltage supplied to each of the control terminal 11 and the band control terminal of the active filter 3 by the first adjustment resistor 5₁ and/or the second adjustment resistor 5₂ becomes equal to the voltage value of the already detected output voltage of the voltage variable power supply 13. In this case, the cutting off or disconnection of the connecting portion of the first adjustment resistor 5₁ or the second adjustment resistor 5₂ is carried out by, for example, applying laser light to the connecting portion and melting or fusing the connecting portion. Incidentally, when the voltage value of the control voltage is set to the minimum voltage value of the output voltage of the voltage variable power supply 13, the connecting portion of the first adjustment resistor 5₁ may be cut off from the control terminal 11 and only the second adjustment resistor 5₂ may be connected thereto. When the voltage value of the control voltage is set to the intermediate voltage value of the output voltage of the voltage variable power supply 13, the first adjustment resistor 5₁ and the second adjustment resistor 5₂ may be connected to the control terminal 11 without cutting off the connecting portions of the first adjustment resistor 5₁ and the second adjustment resistor 5₂ therefrom. When the voltage value of the control voltage is set to the maximum voltage value of the output voltage produced from the voltage variable power supply 13, the connecting portion of the second adjustment resistor 5₂ may be cut off and only the first adjustment resistor 5₁ may be connected to the control terminal 11.

Owing to the execution of such an adjustment or control process, the receive sensitivity of the receiver can be set to the maximum by always supplying a control voltage having such a voltage value as to compensate for a reduction in the receive sensitivity of the receiver to the band control terminal of the active filter 3 which constitutes the intermediate frequency filter even if the receive sensitivity of the receiver is lowered due to variations in the characteristic of the integrated circuit 12. Since the voltage value of the control voltage supplied to the band control terminal of the active filter 3 is set according to the selective disconnection or cutting off of the connecting portions of the first adjustment resistor 5₁ and the second adjustment resistor 5₂ laid out upon manufacture, extra constitutional parts become unnecessary and the transmitter-receiver of the DECT system including the active filter 3 thereinside does not result in an increase in manufacturing cost and lead to an increase in the whole structure thereof.

On the other hand, the active filter 3 according to the above embodiment is one configured by providing the first adjustment resistor 5₁ and the second adjustment resistor 5₂ in the integrated circuit 12 in advance and suitably cutting off the connecting portions of the first adjustment resistor 5₁ and/or the second adjustment resistor 5₂. However, the active filter 3 used in the present invention is not limited to one wherein the first adjustment resistor 5₁ and the second adjustment resistor 5₂ are provided in the integrated circuit 12 in advance. The first adjustment resistor 5₁ and/or the second adjustment resistor 5₂ may be connected to each other upon the adjusting process without providing the first adjustment resistor 5₁ and the second adjustment resistor 5₂ in the integrated circuit 12 in advance. In this case, the integrated circuit 12 is provided with respective connecting portions of the first adjustment resistor 5₁ and the second adjustment resistor 5₂, specifically, respective connecting portions of the band control terminal of the active filter 3 and the control terminal 11, a connecting portion of the power terminal 6, and a connecting portion of the ground point. When it is necessary to connect the first adjustment resistor 5₁ according to the adjusting process, the first adjustment resistor 5₁ is connected between the corresponding connecting portions, when it is necessary to connect the second adjustment resistor 5₂, the second adjustment resistor 5₂ is connected between the corresponding connecting portions, and when it is necessary to connect the first adjustment resistor 5₁ and the second adjustment resistor 5₂, the first adjustment resistor 5₁ and the second adjustment resistor 5₂ are connected to each other as described above, respectively.

Incidentally, the above-described embodiment has been described by the example in which the active filter 3 is used in the receiver provided in the transmitter-receiver of the DECT system. However, the active filter 3 according to the present invention is not limited to such an application. If the active filter 3 is one which is incorporated into the integrated circuit 12 and exhibits variations in the characteristic of the integrated circuit 12, then it may be used in a receiver intended for another application.

Further, the above-described embodiment has been described by the example in which the respective resistance values of the first adjustment resistor 5₁ and the second adjustment resistor 5₂ are respectively 10kΩ. However, the respective resistance values of the first adjustment resistor 5₁ and the second adjustment resistor 5₂ are not limited to 10kΩ. If ones having resistance values close to such a resistance value are used, then ones having other resistance values may be used.

Furthermore, the above-described embodiment has been described by the example in which the output voltage of the variable voltage source or supply connected to the control terminal 11 is changed to the three stages of the maximum voltage, the intermediate voltage and the minimum voltage. However, the variable voltage supply 13 employed in the present invention is not limited to such a configuration. If one whose output voltage changes stepwise, is used, then the variable voltage supply does not necessarily require one whose output voltage is changed to the three stages.

According to a method of adjusting a band of an active filter according to the present invention as described above, when a voltage supplied to a control terminal connected to the active filter is set upon an adjusting process so that the receive sensitivity of a receiver reaches a maximum, connecting portions of a first adjustment resistor connected between the control terminal and an internal power terminal and/or a second adjustment resistor connected between the control terminal and a ground point are simply maintained as they are or the connecting portions are simply cut off. Therefore, an advantageous effect is brought about in that newly-connected constitutional parts become unnecessary, and hence the size of a storage container can be reduced except for a portion occupied by the constitutional parts as well as a reduction in the cost equivalent to the constitutional parts, whereby the manufacturing cost of the active filter section or portion can be lowered and the entire structure including the active filter can be brought into less size.

According to an active filter of the present invention as well, when the receive sensitivity of a receiver is set so as to reach a maximum, a voltage supplied to a control terminal connected to the active filter is set upon an adjusting process in such a manner that a first adjustment resistor connected between the control terminal and an internal power terminal and/or a second adjustment resistor connected between the control terminal and a ground point are brought to a connected state or a disconnected state. Therefore, an advantageous effect is brought about in that as compared with the case in which at least one variable resistor is used as a component or constitutional part newly connected to the control terminal, the cost equivalent to the constitutional part is reduced, and the size of a storage container is reduced because a slight preparation for a portion occupied by the constitutional part will suffice, whereby the manufacturing cost of the active filter portion or section can be lowered and the entire structure including the active filter can be brought into less size.

## Claims

1. A method of adjusting a band of an active filter, including the active filter used in a receiver and whose band is adjusted by a voltage value supplied to a control terminal, a cutable-off first adjustment resistor connected between the control terminal and an internal power terminal, a cutable-off second adjustment resistor connected between the control terminal and a ground point, and an external power supply selectively connected to the control terminal and whose output voltage is capable of being adjusted stepwise, which comprises the following steps of:
first connecting the external power supply to the control terminal;
changing the output voltage of the external power supply stepwise;
measuring receive sensitivity of the receiver each time the output voltage is changed;
detecting the output voltage of the external power supply at the acquisition of the maximum receive sensitivity;
next disconnecting the external power supply from the control terminal; and
adjusting the states of connections of the first adjustment resistor and the second adjustment resistor to allow the voltage at the control terminal to be substantially equal to the detected output voltage.

2. A method of adjusting a band of an active filter, including the active filter employed in a receiver and whose band is adjusted by a voltage value supplied to a control terminal, an internal power terminal disposed close to the control terminal, a ground terminal placed close to the control terminal, and an external power supply selectively connected to the control terminal and whose voltage is capable of being adjusted stepwise, which comprises the following steps of:
first connecting the external power supply to the control terminal;
changing the voltage of the external power supply stepwise;
measuring receive sensitivity of the receiver each time the voltage is changed;
detecting the voltage of the external power supply at the acquisition of the maximum receive sensitivity;
next disconnecting the external power supply from the control terminal; and
connecting a first adjustment resistor between the control terminal and the internal power terminal and/or a second adjustment resistor between the control terminal and the ground terminal to allow the voltage at the control terminal to be substantially equal to the detected voltage.

3. The method according to claim 1 or 2, wherein the external power supply is capable of generating output voltages corresponding to three stages of a maximum voltage, an intermediate voltage and a minimum voltage.

4. An active filter including an active filter employed in a receiver and whose band is adjusted by a voltage value supplied to a control terminal, a connector to which an external power supply connected to the control terminal and whose voltage is capable of being adjusted stepwise, is connectable, and adjustment resistors connected between the control terminal and an internal power terminal and/or between the control terminal and a ground point so as to measure receive sensitivity of the receiver and thereby obtain the maximum receive sensitivity.
